# EUROPEAN PATENT APPLICATION

(11) **EP 1 876 262 A1**
(43) Date of publication of application: **09.01.2008**
(21) Application number: 07252710.4
(22) Date of filing: 05.07.2007
(51) Int. Cl.: C23C 18/40, C23C 18/16

(54) **Environmentally friendly electroless copper compositions**

(30) Priority: 07.07.2006 US 819246 P
(71) Applicant: Rohm and Haas Electronic Materials, L.L.C., Marlborough, Massachusetts 01752 (US)
(72) Inventor: Poole, Mark A., Shrewsbury, MA 01545 (US); Cobley, Andrew J., Coventry West Midlands CV5 9EY (GB); Singh, Amrik, Coventry West Midlands CV1 5HL (GB); Hirst, Deborah V., Nuneaton, Warwickshire CV11 4FS (GB)
(74) Representative: Buckley, Guy Julian

(57) **Abstract**

Electroless copper and copper alloy plating baths are disclosed. The electroless baths are formaldehyde free and are environmentally friendly. The electroless baths are stable and deposit a bright copper on substrates.

## Description

The present invention is directed to environmentally friendly alkaline electroless copper compositions. More specifically, the present invention is directed to environmentally friendly alkaline electroless copper compositions which provide improved copper deposition.

Electroless copper plating compositions, also known as baths, are in widespread use in metallization industries for depositing copper on various types of substrates. In the manufacture of printed wiring boards, for example, the electroless copper baths are used to deposit copper into through-holes and circuit paths as a base for subsequent electrolytic copper plating. Electroless copper plating also is used in the decorative plastics industry for deposition of copper onto non-conductive surfaces as a base for further plating of copper, nickel, gold, silver and other metals as required. Typical baths which are in commercial use today contain divalent copper compounds, chelating agents or complexing agents for the divalent copper ions, formaldehyde reducing agents and various addition agents to make the bath more stable, adjust the plating rate and brighten the copper deposit. Although many of such baths are successful and are widely used, the metallization industry has been searching for alternative electroless copper plating baths that do not contain formaldehyde due to its toxic nature.

Formaldehyde is known as an eye, nose and upper respiratory tract irritant. Animal studies have shown that formaldehyde is an *in vitro* mutagen. According to a WATCH committee report (WATCH/2005/06 - Working group on Action to Control Chemicals - sub committee with UK Health and Safety Commission) over fifty epidemiological studies have been conducted prior to 2000 suggested a link between formaldehyde and nasopharyngeal/nasal cancer but were not conclusive. However, more recent studies conducted by IARC (International Agency for Research on Cancer) in the U.S.A. showed that there was sufficient epidemiological evidence that formaldehyde causes nasopharyngeal cancer in humans. As a result the INRS, a French agency, has submitted a proposal to the European Community Classification and Labelling Work Group to reclassify formaldehyde from a category 3 to a category 1 carcinogen. This would make usage and handling of it more restricted, including in electroless copper formulations. Accordingly, there is a need in the metallization industry for a comparable or improved reducing agent to replace formaldehyde. Such a reducing agent must be compatible with existing electroless copper processes; provide desired capability and reliability and meet cost targets.

Hypophosphites have been suggested as a replacement for formaldehyde; however, plating rates of baths containing this compound are generally too slow. Compounds such as boron hydride salts and dimethylamine borane (DMAB) are included as reducing agents. However, such boron containing compounds have been tried with varying degrees of success. Further, these compounds are more expensive than formaldehyde and also have health and safety issues. DMAB is toxic. Additionally, resultant borates have adverse effects on crops on release into the environment.

In addition to the environmental problems, the metallization industry requires alternative reducing agents which do not adversely affect plating bath stability due to component incompatibilities. Further, the baths must meet industry standards with respect to bath stability and the quality of copper deposits. The baths should not form copper oxide precipitates. The copper deposits must at least meet industry standards for backlight values and eliminate or reduce potential of interconnect defect (ICD) formation.

Typically, backlight values greater than 4 indicate that an electroless copper bath deposits a sufficiently uniform copper layer on a substrate to provide reliable electrical conductivity. In addition such values indicate good copper adhesion. Poor adhesion typically results in ICDs in electronic articles. For example, a uniform copper deposit with good adhesion is critical on through-hole walls of printed wiring boards. Uniform copper deposits on the walls of the through-holes enable optimum electrical communication between adjacent wiring boards in multi-layer printed wiring boards. Good adhesion prevents ICDs between boards (i.e. dark lines at the interface between deposited copper innerlayers). Insufficient electrical communication between two adjacent boards in electronic articles due to defective copper deposits results in operational failure of the article. Accordingly, electroless copper baths which have good backlight values are critical to the metallization industry.

U.S. 6,660,071 discloses electroless copper baths which are formaldehyde free. The electroless copper bath includes glyoxylic acid as an alternative for formaldehyde. The electroless copper baths also include carboxylic acids as reaction accelerators to accelerate the oxidation reaction of the reducing agent. Such acids are glycolic acid, acetic acid, glycine, oxalic acid, succinic acid, malic acid, malonic acid, citric acid and nitrilotriacetic acid. The bath allegedly has a plating reaction velocity equivalent to that of a bath which contains formaldehyde as a reducing agent.

Although there are formaldehyde free electroless copper baths, there is still a need for an electroless copper bath which is free of formaldehyde and environmentally friendly and provides industry acceptable copper deposits.

In one aspect compositions include one or more sources of copper ions, one or more thiocarboxylic acids, glyoxylic acid and salts thereof and one or more alkaline compounds to maintain the composition alkaline.

In another aspect, methods include a) providing a substrate; and b) electrolessly depositing copper on the substrate using an electroless copper composition including one or more sources of copper ions, one or more thiocarboxylic acids, glyoxylic acid and salts thereof and one or more alkaline compounds to maintain the composition alkaline.

In a further aspect, methods include a) providing a printed wiring board having a plurality of through-holes; b) desmearing the through-holes; and c) depositing copper on walls of the through-holes using an electroless copper composition including one or more sources of copper ions, one or more thiocarboxylic acids, glyoxylic acid and salts thereof and one or more alkaline compounds to maintain the composition alkaline.

In still another aspect, the electroless copper compositions may include one or more additional metal ions to deposit a copper alloy on a substrate. Such additional metal ions include tin and nickel.

The electroless copper compositions are formaldehyde free and are environmentally friendly and stable. The environmentally friendly electroless copper compositions provide uniform copper deposits as shown by backlight values exceeding 4. Additionally, the copper deposits have good adhesion to their substrates as shown by a lack of ICDs.

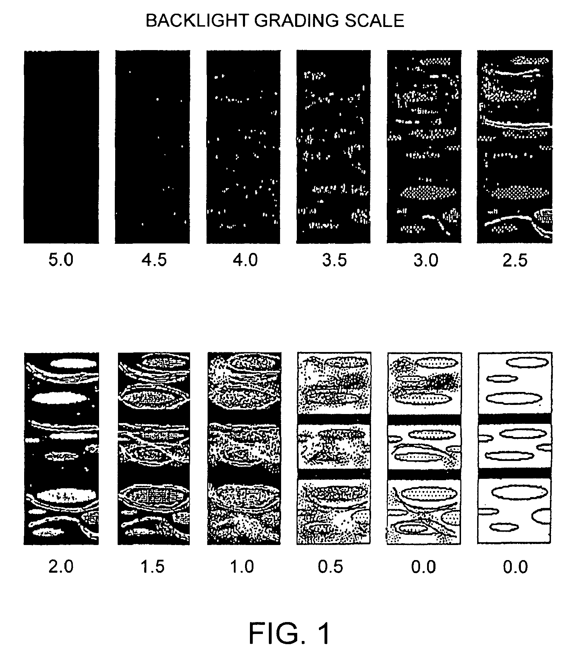

The Figure illustrates a European Backlight Grading Scale of 0 to 5 to show the amount of copper coverage on through-hole walls.

As used throughout this specification, the abbreviations given below have the following meanings, unless the context clearly indicates otherwise: g = gram; mg = milligram; ml = milliliter; L = liter; cm = centimeter; m = meter; mm = millimeter; µm = micron; min. = minute; s = second; ppm = parts per million; ° C = degrees Centigrade; M = molar; g/L = grams per liter; wt% = percent by weight; T_{g} = glass transition temperature; and dyne = 1 g-cm/s² = (10⁻³ Kg) (10⁻² m)/s² = 10⁻⁵ Newtons.

The terms "printed circuit board" and "printed wiring board" are used interchangeably throughout this specification. The terms "plating" and "deposition" are used interchangeably throughout this specification. A dyne is a unit of force. All amounts are percent by weight, unless otherwise noted. All numerical ranges are inclusive and combinable in any order except where it is logical that such numerical ranges are constrained to add up to 100%.

Alkaline electroless copper compositions are formaldehyde free and are environmentally friendly. The alkaline electroless copper compositions provide uniform copper deposits on substrates with good adhesion. The alkaline electroless copper compositions include one or more sources of copper ions, one or more thiocarboxylic acids, glyoxylic acid and salts thereof and one or more alkaline compounds to maintain the compositions alkaline. Conventional additives also may be included in the compositions. Additives include, but are not limited to, one or more complexing agents, antioxidants, stabilizers such as those which adjust mechanical properties, provide rate control, refine grain structure and modify deposit stress, buffering agents, surfactants and one or more sources of alloying metals.

Sources of copper ions include, but are not limited to, water soluble halides, nitrates, acetates, sulfates and other organic and inorganic salts of copper. Mixtures of one or more of such copper salts may be used to provide copper ions. Examples include copper sulfate, such as copper sulfate pentahydrate, copper chloride, copper nitrate, copper hydroxide and copper sulfamate. Conventional amounts of copper salts may be used in the compositions. Copper ion concentrations in the compositions may range from 0.5 g/L to 30 g/L or such as from 1 g/L to 20 g/L or such as from 5 g/L to 10 g/L.

Chelating agents are chosen from one or more thiocarboxylic acids. Such acids include, but are not limited to compounds having a formula:

HS-(CX₁)ᵣ-(CHX₂)ₛ-COOH

where X₁ is -H or -COOH; X₂ is -H or -SH; r and s are positive integers where r is 0 to 2, or 0 or 1; and s is 1 or 2. Examples of such thiocarboxylic acid are thioglycolic acid, thiopropionic acid, thiomalic acid and dithiodisuccinic acid. Such thiocarboxylic acids are compatible with glyoxylic acid and its salts and stabilize the electroless copper compositions by preventing the formation of copper oxide. Thiocarboxylic acids are included in the electroless copper compositions in amounts of 0.01 ppm to 20 ppm or such as from 0.25 ppm to 10 ppm or such as from 0.5 ppm to 5 ppm.

Glyoxylic acid and its salts function as a reducing agent and replaces the environmentally unfriendly formaldehyde, which is known carcinogen. Glyoxylic acid is not a carcinogen. Glyoxylic acid is included in amounts of 10 g/L to 100 g/l or such as from 20 g/L to 80 g/L or such as from 30 g/L to 60 g/L.

Surfactants also may be included in the compositions. Conventional surfactants may be included in the compositions. Such surfactants include ionic, such as cationic and anionic surfactants, non-ionic and amphoteric surfactants. Mixtures of the surfactants may be used. Surfactants may be included in the compositions in amounts of 0.001 g/L to 50 g/L or such as from 0.01 g/L to 50 g/L.

Cationic surfactants include, but are not limited to, tetra-alkylammonium halides, alkytrimethylammonium halides, hydroxyethyl alkyl imidazoline, alkylbenzalkonium halides, alkylamine acetates, alkylamine oleates and alkylaminoethyl glycine.

Anionic surfactants include, but are not limited to, alkylbenzenesulfonates, alkyl or alkoxy napthalenesulfonates, alkyldiphenyl ether sulfonates, alkyl ether sulfonates, alkylsulfuric esters, polyoxyethylene alkyl ether sulfuric esters, polyoxyethylene alkyl phenol ether sulfuric esters, higher alcohol phosphoric monoesters, polyoxyalkylene alkyl ether phosphoric acids (phosphates) and alkyl sulfosuccinates.

Amphoteric surfactants include, but are not limited to, 2-alkyl-N-carboxymethyl or ethyl-N-hydroxyethyl or methyl imidazolium betaines, 2-alkyl-N-carboxymethyl or ethyl-N-carboxymethyloxyethyl imidazolium betaines, dimethylalkyl betaines, N-alkyl-β-aminopropionic acids or salts thereof and fatty acid amidopropyl dimethylaminoacetic acid betaines.

Typically the surfactants are non-ionic. Non-ionic surfactants include, but are not limited to, alkyl phenoxy polyethoxyethanols, polyoxyethylene polymers having from 20 to 150 repeating units and block copolymers of polyoxyethylene and polyoxypropylene. Surfactants may be used in conventional amounts.

Antioxidants include, but are not limited to, monohydric, dihydric and trihydric phenols in which a hydrogen atom or atoms may be unsubstituted or substituted by - COOH, -SO₃H, lower alkyl or lower alkoxy groups, hydroquinone, catechol, resorcinol, quinol, pyrogallol, hydroxyquinol, phloroglucinol, guaiacol, gallic acid, 3,4-dihydroxybenzoic acid, phenolsulfonic acid, cresolsulfonic acid, hydroquinonsulfonic acid, catecholsulfonic acid, tiron and salts thereof. Antioxidants are included in the compositions in conventional amounts.

Alkaline compounds are included in the electroless copper plating compositions to maintain a pH of at least 9. A high alkaline pH is desirable because oxidation potentials for reducing agents are shifted to more negative values as the pH increases thus making the copper deposition thermodynamically favorable. Typically the electroless copper plating compositions have a pH from 10 to 14. More typically the electroless copper plating compositions have a pH from 11.5 to 13.5.

One or more compounds which provide an alkaline composition within the thermodynamically favorable pH ranges are used. Alkaline compounds include, but are not limited to, one or more alkaline hydroxides such as sodium hydroxide, potassium hydroxide and lithium hydroxide. Typically sodium hydroxide, potassium hydroxide or mixtures thereof are used. More typically potassium hydroxide is used. Such compounds may be included in amounts of 5 g/L to 100 g/L or such as from 10 g/L to 80 g/L.

One or more alloying metals also may be included in the electroless compositions to form alloys of copper. Such alloying metals include, but are not limited to, nickel and tin. Examples of copper alloys include copper/nickel and copper/tin. Typically the copper alloy is copper/nickel.

Sources of nickel ions may include one or more conventional water soluble salts of nickel. Sources of nickel ions include, but are not limited to, nickel sulfates and nickel halides. Sources of nickel ions may be included in the electroless alloying compositions in conventional amounts. Typically sources of nickel ions are included in amounts of 0.5 g/L to 10 g/L or such as from 1 g/l to 5 g/L.

Sources of tin ions may include one or more conventional water soluble salts of tin. Sources of tin ions include, but are not limited to, tin sulfates, tin halides and organic tin sulfonates. Sources of tin ions may be included in the electroless compositions in conventional amounts. Typically sources of tin ions are included in amounts of 0.5 g/L to 10 g/L or such as 1 g/L to 5 g/L.

Other additives may be included in the alkaline electroless copper and copper alloy compositions to tailor them for optimum performance. Many of such additives are conventional for electroless copper and copper alloy compositions and are well known in the art.

Optional conventional additives include, but are not limited to, sulfur containing compounds such as mercaptopyridine, mercaptobenzothiazole, thiourea; compounds such as pyridine, purine, quinoline, indole, indazole, imidazole, pyrazine and their derivatives; alcohols such as alkyne alcohols, allyl alcohols, aryl alcohols and cyclic phenols; hydroxy substituted aromatic compounds such as methyl-3,4,5-trihydroxybenzoate, 2,5-dihydroxy-1,4-benzoquinone and 2,6-dihydroxynaphthalene; carboxylic acids, such as citric acid, tartaric acid, succinic acid, malic acid, malonic acid, lactic acid, acetic acid and salts thereof; amines; amino acids; aqueous soluble metal compounds such as metal chlorides and sulfates; silicon compounds such as silanes, siloxanes and low to intermediate molecular weight polysiloxanes; germanium and its oxides and hydrides; and polyalkylene glycols, cellulose compounds, alkylphenyl ethoxylates and polyoxyethylene compounds; and stabilizers such as pyridazine, methylpiperidine, 1,2-di-(2-pyridyl)ethylene, 1,2-di-(pyridyl)ethylene, 2,2'-dipyridylamine, 2,2'-bipyridyl, 2,2'-bipyrimidine, 6,6'-dimethyl-2,2'-dipyridyl, di-2-pyrylketone, N,N,N',N'-tetraethylenediamine, naphthalene, 1,8-naphthyridine, 1,6-naphthyridine, tetrathiafurvalene, terpyridine, pththalic acid, isopththalic acid and 2,2'-dibenzoic acid. Such additives may be included in the electroless copper compositions in amounts of 0.01 ppm to 1000 ppm or such as from 0.05 ppm to 10 ppm.

Other conventional additives include, but are not limited to, Rochelle salts, sodium salts of ethylenediamine tetraacetic acid, nitriloacetic acid and its alkali metal salts, triethanolamine, modified ethylene diamine tetraacetic acids such as N-hydroxyethylenediamine triacetate, hydroxyalkyl substituted dialkaline triamines such as pentahydroxy propyldiethylenetriamine and compounds such as N, N-dicarboxymethyl L-glutamic acid tetrasodium salt. Also s,s-ethylene diamine disuccinic acid and N,N,N',N'-tetrakis (2-hydroxypropyl) ethytlenediamine (ethylenedinitrilo) tetra-2-propanol may be included. Such additives typically function as complexing agents for keeping copper (II) in solution. Such complexing agents may be included in the compositions in conventional amounts. Typically such complexing agents are included in amounts of from 1 g/L to 50 g/l or such as from 10 g/L to 40 g/L.

The alkaline electroless copper compositions may be used to deposit copper on both conductive and non-conductive substrates. The alkaline electroless copper compositions may be used in many conventional methods known in the art. Typically copper deposition is done at temperatures of 20° C to 80° C. More typically the electroless compositions deposit copper at temperatures of 30° C to 60° C. The substrate to be plated with copper is immersed in the electroless composition or the electroless composition is sprayed onto the substrate. Conventional plating times may be used to deposit the copper onto the substrate. Deposition may be done for 5 seconds to 30 minutes; however, plating times may vary depending on the thickness of the copper desired.

Substrates include, but are not limited to, materials including inorganic and organic substances such as glass, ceramics, porcelain, resins, paper, cloth and combinations thereof. Metal-clad and unclad materials also are substrates which may be plated with the electroless copper and copper alloy compositions.

Substrates also include printed circuit boards. Such printed circuit boards include metal-clad and unclad with thermosetting resins, thermoplastic resins and combinations thereof, including fiber, such as fiberglass, and impregnated embodiments of the foregoing.

Thermoplastic resins include, but are not limited to, acetal resins, acrylics, such as methyl acrylate, cellulosic resins, such as ethyl acetate, cellulose propionate, cellulose acetate butyrate and cellulose nitrate, polyethers, nylon, polyethylene, polystyrene, styrene blends, such as acrylonitrile styrene and copolymers and acrylonitrile-butadiene styrene copolymers, polycarbonates, polychlorotrifluoroethylene, and vinylpolymers and copolymers, such as vinyl acetate, vinyl alcohol, vinyl butyral, vinyl chloride, vinyl chloride-acetate copolymer, vinylidene chloride and vinyl formal.

Thermosetting resins include, but are not limited to, allyl phthalate, furane, melamine-formaldehyde, phenol-formaldehyde and phenol-furfural copolymers, alone or compounded with butadiene acrylonitrile copolymers or acrylonitrile-butadiene-styrene copolymers, polyacrylic esters, silicones, urea formaldehydes, epoxy resins, allyl resins, glyceryl phthalates and polyesters.

Porous materials include, but are not limited to paper, wood, fiberglass, cloth and fibers, such as natural and synthetic fibers, such as cotton fibers and polyester fibers.

The alkaline electroless copper compositions may be used to plate both low and high T_{g} resins. Low T_{g} resins have a T_{g} below 160° C and high T_{g} resins have a T_{g} of 160° C and above. Typically high T_{g} resins have a T_{g} of 160° C to 280° C or such as from 170° C to 240° C. High T_{g} polymer resins include, but are not limited to, polytetrafluoroethylene (PTFE) and polytetrafluoroethylene blends. Such blends include, for example, PTFE with polypheneylene oxides and cyanate esters. Other classes of polymer resins which include resins with a high T_{g} include, but are not limited to, epoxy resins, such as difunctional and multifunctional epoxy resins, bimaleimide/triazine and epoxy resins (BT epoxy), epoxy/polyphenylene oxide resins, acrylonitrile butadienestyrene, polycarbonates (PC), polyphenylene oxides (PPO), polypheneylene ethers (PPE), polyphenylene sulfides (PPS), polysulfones (PS), polyamides, polyesters such as polyethyleneterephthalate (PET) and polybutyleneterephthalate (PBT), polyetherketones (PEEK), liquid crystal polymers, polyurethanes, polyetherimides, epoxies and composites thereof.

In one embodiment the alkaline electroless compositions may be used to deposit copper on the walls of through-holes or vias of printed circuit boards. The electroless compositions may be used in both horizontal and vertical processes of manufacturing printed circuit boards.

In one embodiment through-holes are formed in the printed circuit board by drilling or punching or any other method known in the art. After the formation of the through-holes, the boards are rinsed with water and a conventional organic solution to clean and degrease the board followed by desmearing the through-hole walls. Typically desmearing of the through-holes begins with application of a solvent swell.

Any conventional solvent swell may be used to desmear the through-holes. Solvent swells include, but are not limited to, glycol ethers and their associated ether acetates. Conventional amounts of glycol ethers and their associated ether acetates may be used. Such solvent swells are well known in the art. Commercially available solvent swells include, but are not limited to, CIRCUPOSIT CONDITIONER™ 3302, CIRCUPOSIT HOLE PREP™ 3303 and CIRCUPOSIT HOLE PREP™ 4120 (obtainable from Rohm and Haas Electronic Materials, Marlborough, MA).

Optionally, the through-holes are rinsed with water. A promoter is then applied to the through-holes. Conventional promoters may be used. Such promoters include sulfuric acid, chromic acid, alkaline permanganate or plasma etching. Typically alkaline permanganate is used as the promoter. An example of a commercially available promoter is CIRCUPOSIT PROMOTER™ 4130 available from Rohm and Haas Electronic Materials, Marlborough, MA.

Optionally, the through-holes are rinsed again with water. A neutralizer is then applied to the through-holes to neutralize any residues left by the promoter. Conventional neutralizers may be used. Typically the neutralizer is an aqueous alkaline solution containing one or more amines or a solution of 3wt% peroxide and 3wt% sulfuric acid. Optionally, the through-holes are rinsed with water and the printed circuit boards are dried.

After desmearing an acid or alkaline conditioner may be applied to the through-holes. Conventional conditioners may be used. Such conditioners may include one or more cationic surfactants, non-ionic surfactants, complexing agents and pH adjusters or buffers. Commercially available acid conditioners include, but are not limited to, CIRCUPOSIT CONDITIONER™ 3320 and CIRCUPOSIT CONDITIONER™ 3327 available from Rohm and Haas Electronic Materials, Marlborough, MA. Suitable alkaline conditioners include, but are not limited to, aqueous alkaline surfactant solutions containing one or more quaternary amines and polyamines. Commercially available alkaline surfactants include, but are not limited to, CIRCUPOSIT CONDITIONER™ 231, 3325, 813 and 860 available from Rohm and Haas Electronic Materials. Optionally, the through-holes are rinsed with water after conditioning.

Conditioning is followed by microetching the through-holes. Conventional microeteching compositions may be used. Microetching is designed to provide a micro-roughened copper surface on exposed copper (e.g. innerlayers and surface etch) to enhance subsequent adhesion of deposited electroless and electroplate. Microetches include, but are not limited to, 60 g/L to 120 g/L sodium persulfate or sodium or potassium oxymonopersulfate and sulfuric acid (2%) mixture, or generic sulfuric acid/hydrogen peroxide. An example of a commercially available microetching composition includes CIRCUPOSIT MICROETCH™ 3330 available from Rohm and Haas Electronic Materials. Optionally, the through-holes are rinsed with water.

A pre-dip is then applied to the microeteched through-holes. Examples of pre-dips include 2% to 5% hydrochloric acid or an acidic solution of 25 g/L to 75 g/L of sodium chloride. Optionally, the through-holes are rinsed with cold water.

A catalyst is then applied to the through-holes. Any conventional catalyst may be used. The choice of catalyst depends on the type of metal to be deposited on the walls of the through-holes. Typically the catalysts are colloids of noble and non-noble metals. Such catalysts are well known in the art and many are commercially available or may be prepared from the literature. Examples of non-noble metal catalysts include copper, aluminum, cobalt, nickel, tin and iron. Typically noble metal catalysts are used. Suitable noble metal colloid catalysts include, for example, gold, silver, platinum, palladium, iridium, rhodium, ruthenium and osmium. More typically, noble metal catalysts of silver, platinum, gold and palladium are used. Most typically silver and palladium are used. Suitable commercially available catalysts include, for example, CIRCUPOSIT CATALYST™ 334 and CATAPOSIT™ 44 available from Rohm and Haas Electronic Materials. The through-holes optionally may be rinsed with water after application of the catalysts.

The walls of the through-holes are then plated with copper with an alkaline electroless composition as described above. Plating times and temperatures are described above.

After the copper is deposited on the walls of the through-holes, the through-holes are optionally rinsed with water. Optionally, anti-tarnish compositions may be applied to the metal deposited on the walls of the through-holes. Conventional anti-tarnish compositions may be used. Examples of anti-tarnish compositions include ANTI TARNISH™ 7130 and CUPRATEC™ 3 (obtainable from Rohm and Haas Electronic Materials). The through-holes may optionally be rinsed by a hot water rinse at temperatures exceeding 30° C and then the boards may be dried.

In an alternative embodiment the through-holes may be treated with an alkaline hydroxide solution after desmear to prepare the through-holes for electroless deposition of copper. This alternative embodiment for plating through-holes or vias is typically used when preparing high T_{g} boards for plating. The alkaline hydroxide solution contacts the through-holes for 30 seconds to 120 seconds or such as from 60 seconds to 90 seconds. Application of the alkaline hydroxide composition between the desmearing and plating the through-holes provides for good coverage of the through-hole walls with the catalyst such that the copper covers the walls. The alkaline hydroxide solution is an aqueous solution of sodium hydroxide, potassium hydroxide or mixtures thereof. The hydroxides are included in amounts of 0.1 g/L to 100 g/L or such as from 5 g/L to 25 g/L. Typically the hydroxides are included in the solutions in amounts of 15 g/L to 20 g/l. Typically the alkaline hydroxide is sodium hydroxide. If the alkaline hydroxide solution is a mixture of sodium hydroxide and potassium hydroxide, the sodium hydroxide and potassium hydroxide are in a weight ratio of 4:1 to 1:1, or such as from 3:1 to 2:1.

Optionally one or more surfactants may be added to the alkaline hydroxide solution. Typically the surfactants are non-ionic surfactants. The surfactants reduce surface tension to enable proper wetting of the through-holes. Surface tension after application of the surfactant in the through-holes ranges from 25 dynes/cm to 50 dynes/cm, or such as from 30 dynes/cm to 40 dynes/cm. Typically the surfactants are included in the formulation when the alkaline hydroxide solution is used to treat small through-holes to prevent flaring. Small through-holes typically range in diameter of 0.2 mm to 0.5 mm. In contrast, large through-holes typically range in diameter of 0.5 mm to 1 mm. Aspect ratios of through-holes may range from 1:1 to 20:1.

Surfactants are included in the alkaline hydroxide solutions in amounts of 0.05wt% to 5wt%, or such as from 0.25wt% to 1wt%. Suitable non-ionic surfactants include, for example, aliphatic alcohols such as alkoxylates. Such aliphatic alcohols have ethylene oxide, propylene oxide, or combinations thereof, to produce a compound having a polyoxyethylene or polyoxypropylene chain within the molecule, i.e., a chain composed of recurring (-O-CH₂-CH₂-) groups, or chain composed of recurring (-O-CH₂-CH-CH₃) groups, or combinations thereof. Typically such alcohol alkoxylates are alcohol ethoxylates having carbon chains of 7 to 15 carbons, linear or branched, and 4 to 20 moles of ethoxylate, typically 5 to 40 moles of ethoxylate and more typically 5 to 15 moles of ethoxylate.

Many of such alcohol alkoxylates are commercially available. Examples of commercially available alcohol alkoxylates include, for example, linear primary alcohol ethoxylates such as NEODOL 91-6, NEODOL 91-9 (C₉-C₁₁ alcohols having an average of 6 to 9 moles of ethylene oxide per mole of linear alcohol ethoxylate) and NEODOL 1-73B (C₁₁ alcohol with an average blend of 7 moles of ethylene oxide per mole of linear primary alcohol ethoxylate). Both are available from Shell Oil Company, Houston Texas.

After the through-holes are treated with the alkaline hydroxide solution, they may be treated with an acid or alkaline conditioner. The through-holes are then micro-etched and applied with a pre-dip followed by applying a catalyst. The through-holes are then electrolessly plated with copper.

After the through-holes are plated with copper, the substrates may undergo further processing. Further processing may include conventional processing by photoimaging and further metal deposition on the substrates such as electrolytic metal deposition of, for example, copper, copper alloys, tin and tin alloys.

While not being bound by theory, the thiocarboxylic acid chelating agents in combination with glyoxylic acid enable a controlled autocatalytic deposition of copper on substrates. These chelating agents in combination with glyoxylic acid prevent the formation of copper oxide (Cu₂O) in the bath. Copper oxide is readily formed in many formaldehyde free conventional electroless copper plating solutions at high pH ranges. Such copper oxide formation destabilizes the electroless copper compositions and compromises the deposition of copper on substrates. The inhibition of the copper oxide formation enables the autocatalytic process to operate at high pH ranges where copper deposition is thermodynamically favorable.

The electroless copper compositions are free of formaldehyde and are environmentally friendly. They are stable during storage and during electroless deposition. They deposit a uniform copper layer on a substrate as evidenced by backlight values exceeding 4.

The following examples are not intended to limit the scope of the invention but are intended to further illustrate it.

### Example 1 (comparative)

Multiple through-holes were drilled in eight low T_{g} (150° C) FR4 epoxy/glass multi-laminate boards (six layers) and eight high T_{g} (180° C) NELCO 4000-6 multi-laminate boards (six layers). The through-holes in each board were then desmeared in a horizontal desmear line process as follows:
1. Each board was treated with 240 liters of solvent swell for 100 seconds at 80° C. The solvent swell was a conventional aqueous solution of 10% diethylene glycol mono butyl ether, a surfactant and 35 g/L of sodium hydroxide.
2. The boards were then rinsed with cold water.
3. The through-holes in each board were then treated with 550 liters of an alkaline promoter of aqueous alkaline permanganate at a pH of 12 for 150 seconds at 80° C.
4. The boards were then rinsed with cold water.
5. The through-holes in the boards were then treated with 180 liters of an aqueous neutralizer composed of 3wt% hydrogen peroxide and 3wt% sulfuric acid at room temperature for 75 seconds.
6. The boards were then rinsed with cold water.
7. The boards were then treated with 190 liters of the aqueous acid conditioner CIRCUPOSIT CONDITIONER™ 3320 for 60 seconds at 50° C.
8. Each of the boards was then rinsed with cold water.
9. The through-holes of each board were then microetched with 100 liters of an aqueous alkaline solution of 20wt% sodium permanganate and 10wt% sodium hydroxide for 60 minutes at 50° C. Etch rate was 0.5 µm/min. to 1 µm/min.
10. The boards were then rinsed with cold water.
11. A pre-dip was then applied to the through-holes for 40 seconds at room temperature. The pre-dip was Pre-dip™ 3340.
12. The through-holes of each board were then primed for 215 seconds at 40° C with 125 liters of a catalytst for electroless copper metallization of the walls of the through-holes. The catalytst had the following formulation:

**Table 1**

| **COMPONENT** | **AMOUNT** |
|---|---|
| Palladium Chloride (PdCl₂) | 1 g |
| Sodium Stannate (Na₂SnO₃ 3H₂O) | 1.5 g |
| Tin chloride (SnCl₂) | 40 g |
| Water | To one liter |

13. The boards were then rinsed with cold water.
14. The walls of the through-holes of four of the FR4 boards and four of the NELCO boards were then plated with copper using the conventional electroless copper plating bath in Table 2 below. The plating was done for 20 minutes at 55° C at a pH of 13.2.

**Table 2**

| **COMPONENT** | **AMOUNT** |
|---|---|
| Copper sulfate pentahydrate | 5 g |
| Formaldehyde | 2.5 g |
| Potassium hydroxide | 15 g |
| Ethylene diamine tetraacetate (EDTA) | 36 g |
| Thiocarboxylic acid | 15 ppm |
| 2,2-dipyridyl | 11 ppm |
| Water | To one liter |

15. The walls of the through-holes of the other four FR4 boards and the other four NELCO boards were plated with the electroless copper composition shown in the table below. Copper plating was done over 20 minutes at 55° C at a pH of 13.2.

**Table 3**

| **COMPONENT** | **AMOUNT** |
|---|---|
| Copper sulfate pentahydrate | 5 g |
| Glyoxylic acid | 5 g |
| Potassium hydroxide | 10 g |
| Ethylene diamine tetraacetate (EDTA) | 36 g |
| Thiocarboxylic acid | 15 ppm |
| 2,2-dipyridyl | 12 ppm |
| Water | To one liter |

16. After electroless copper deposition the boards were rinsed with cold water.
17. Each board was then sectioned laterally to expose the copper plated walls of the through-holes. Multiple lateral sections 1 mm thick were taken from the walls of the sectioned through-holes of each board to determine the through-hole wall coverage for the boards using the European Backlight Grading Scale.

The Figure is the standard European backlight grading scale used to measure the electroless copper coverage on the walls of the through-holes. 1 mm sections from each board were placed under a conventional optical microscope of 50X magnification. The quality of the copper deposit was determined by the amount of light that was observed under the microscope. If no light was observed, the section was completely black and was rated a 5 on the backlight scale. This indicated complete copper coverage. If light passed through the entire section without any dark areas, this indicated very little to no copper metal deposition on the walls and the section was rated 0. If sections had some dark regions as well as light regions, they were rated between 0 and 5.

The holes and the gaps, as observed by light passing through them, were manually counted for each section while viewing the sections through the microscope. The number of holes and gaps were tallied for each section and the board was given a backlight value based on the backlight scale. The average backlight value for each type of board and bath was determined.

The FR4 and NELCO boards plated with the electroless copper formulation containing formaldehyde had average backlight values of 4.95 and 5, respectively. The FR4 and NELCO boards plated with the electroless copper composition containing glyoxylic acid in place of formaldehyde had backlight values of 4.65 and 4.30, respectively. Although the backlight values for the electroless copper composition containing glyoxylic acid were slightly below the values for the formaldehyde formulation, the glyoxylic acid containing copper composition had backlight values exceeding 4. Such values indicated that the electroless copper formulation containing glyoxylic acid was acceptable for the metallization industry and a good substitute for the environmentally unfriendly formaldehyde.

No copper oxide was observed in any of the electroless copper compositions. Thus, the electroless copper compositions were stable.

The sections were also examined under optical microscopy at 100X and 150X magnifications for ICDs. No ICDs were observed in any of the sections for either bath types.

The results showed that the environmentally friendly glyoxylic acid performed just as well as formaldehyde and was an acceptable substitute for the environmentally unfriendly formaldehyde.

### Example 2 (comparative)

Multiple through-holes were drilled in eight low Tg (150° C) FR4 epoxy/glass multi-laminate boards (six layers) and eight high Tg (180° C) NELCO 4000-6 multi-laminate boards (six layers). The through-holes in each board were then desmeared and plated with copper as described in Example 1 above.

Walls of the through-holes of four of the FR4 boards and four of the NELCO 4000-6 boards were electrolessly plated with copper from a bath having the formulation:

**Table 4**

| **COMPONENT** | **AMOUNT** |
|---|---|
| Copper sulfate pentahydrate | 5 g |
| Formaldehyde | 2.5 g |
| Potassium hydroxide | 15 g |
| Ethylene diamine tetraacetic acid (EDTA) | 36 g |
| Thiocarboxylic acid | 15 ppm |
| Water | To one liter |

Walls of the through-holes of the remaining four FR4 boards and four NELCO 4000-6 boards were plated with copper from an electroless composition having a formula:

**Table 5**

| **COMPONENT** | **AMOUNT** |
|---|---|
| Copper sulfate pentahydrate | 5 g |
| Glyoxylic acid | 5 g |
| Potassium hydroxide | 15 g |
| Ethylene diamine tetraacetic acid (EDTA) | 36 g |
| Thiocarboxylic acid | 15 ppm |
| Water | To one liter |

The boards were sectioned laterally to expose the copper plated walls of the through-holes. Multiple lateral sections 1 mm thick were taken from the walls of the sectioned through-holes of each board to determine the through-hole wall coverage using the European Backlight Grading Scale.

The holes and gaps were manually counted for each section while viewing the sections through an optical microscope of 50X magnification. The number of holes and gaps were tallied for each section and the board was given a backlight value based on the backlight scale. The average backlight value for each type of board and bath was determined.

The FR4 and NELCO boards plated with the electroless copper formulation containing formaldehyde had average backlight values of 4.95 and 4.9, respectively. The FR4 and NELCO boards plated with the electroless copper composition containing glyoxylic acid in place of formaldehyde had backlight values of 4.8 and 4.9. All of the backlight values exceeded 4, including the values from the boards plated with the glyoxylic acid containing composition. Such values indicated that the electroless copper formulation containing glyoxylic acid was acceptable for the metallization industry and a good substitute for the environmentally unfriendly formaldehyde.

No copper oxide was observed in any of the electroless copper compositions. Thus, the electroless copper compositions were stable.

The sections were also examined under optical microscopy at 100X and 150X magnifications for ICDs. No ICDs were observed in any of the sections for either bath types. The results showed that the environmentally friendly glyoxylic acid performed just as well as formaldehyde and was an acceptable substitute for formaldehyde.

## Claims

1. A composition comprising one or more sources of copper ions, one or more thiocarboxylic acids, glyoxylic acid and salts thereof and one or more alkaline compounds to maintain the composition alkaline.

2. The composition of claim 1, wherein the thiocarboxylic acid has a formula:
HS-(CX₁)ᵣ-(CHX₂)ₛ-COOH
wherein X₁ is -H or -COOH; X₂ is -H or -SH; r and s are positive integers where r is 0 to 2, or 0 or 1; and s is 1 or 2.

3. The composition of claim 1, further comprising one or more complexing agents, carboxylic acids, surfactants and antioxidants.

4. The composition of claim 1, wherein the alkaline compounds are chosen from sodium hydroxide, potassium hydroxide and lithium hydroxide.

5. The composition of claim 1, further comprising one or more additional metal ions.

6. The composition of claim 1, wherein the pH is at least 9.

7. A method comprising:
a) providing a substrate; and
b) electrolessly depositing copper on the substrate using an electroless copper composition comprising one or more sources of copper ions, one or more chelating agents chosen thiocarboxylic acids, glyoxylic acid and salts thereof and one or more alkaline compounds to maintain the composition alkaline.

8. A method comprising:
a) providing a printed wiring board comprising a plurality of through-holes;
b) desmearing the through-holes; and
c) depositing copper on walls of the through-holes using an electroless copper bath comprising one or more sources of copper ions, one or more chelating agents chosen from thiocarboxylic acids, glyoxylic acid and salts thereof and one or more alkaline compounds to maintain the composition alkaline.
